# EUROPEAN PATENT SPECIFICATION

(11) **EP 1 029 392 B1**
(45) Date of publication and mention of the grant of the patent: **30.12.2009**
(21) Application number: 98922284.9
(22) Date of filing: 11.05.1998
(51) Int. Cl.: H02N 2/04

(54) **HIGH POWER ULTRASONIC MOTOR**
HOCHLEISTUNGS-ULTRASCHALLMOTOR
MOTEUR A ULTRASONS DE FORTE PUISSANCE

(30) Priority: 13.05.1997 US 855228
(43) Date of publication of application: 23.08.2000
(73) Proprietor: Etrema Products, Inc., Ames, IA 50010 (US)
(72) Inventor: HANSEN, Thomas, T., Ames, IA 50010 (US)
(74) Representative: Merrifield, Sarah Elizabeth
(86) International application number: PCT/US1998/009848
(87) International publication number: WO 1998/052274

(56) References cited:
- DE-A1- 3 245 053
- DE-A1- 19 640 280
- US-A- 2 717 319
- US-A- 2 724 666
- US-A- 2 792 674
- US-A- 3 930 173
- US-A- 3 930 173
- US-A- 4 281 987
- US-A- 4 417 578
- US-A- 4 815 946
- US-A- 5 406 153
- US-A- 5 406 153
- US-A- 5 491 559
- PATENT ABSTRACTS OF JAPAN vol. 014, no. 042 (M-925), 25 January 1990 (1990-01-25) & JP 01 272500 A (KIYOSHI INOUE; others: 01), 31 October 1989 (1989-10-31)

## Description

This invention pertains generally to actuators and, more particularly, to ultrasonic actuators.

US 5,406,153 discusses a magnetorestrictive vibration generation system which includes a Terfenol-D rod actuator with a mass coupled to both ends through a spring seat, a spring seat/adjustor and a spring washer. The actuator is mounted inside a cylindrical coil, which is mounted inside a cylindrical permanent magnet, which is mounted inside a cylindrical housing. An electrical drive system provides a predetermined excitation signal to the coil to cause the rod to vibrate under the influence of a magnetic field generated by the coil. The transducer operates at a maximum power of no greater than about 165 watts.

The present invention provides an ultrasonic motor capable of generating a power in excess of 3 kilowatts as set out in claim 1. The invention will now be described in detail, by way of example only, with reference to the accompanying drawings in which:
Fig. 1 is an isometric view of an ultrasonic actuator of the present invention.
Fig. 2 is a plan view of the ultrasonic motor of Fig. 1.
Fig. 3 is a cross-sectional view of the ultrasonic motor of Fig. 1 taken along the line 3-3 of Fig. 2.
Fig. 4 is an exploded view of the ultrasonic motor of Fig. 1.
Fig. 5 is a sectional view of the ultrasonic motor of Fig. 1 taken along the line 5-5 of Fig. 4.
Fig. 6 is a cross-sectional view of the ultrasonic motor of Fig. 1 taken along the line 6-6 of Fig. 5.
Fig. 7 is a sectional view of the ultrasonic motion of Fig. 1 taken along the line 7-7 of Fig. 4.
Fig. 8 is a cross-sectional view of the ultrasonic motor of Fig. 1 taken along the line 8-8 of Fig. 7.
Fig. 9 is a sectional view of the ultrasonic motor of Fig. 1 taken along the line 9-9 of Fig. 4.
Fig. 10 is a cross-sectional view of the ultrasonic of Fig. 1 taken along the line 10-10 of Fig. 9.
Fig. 11 is a side elevational view of a portion of the ultrasonic motor of Fig. 1.

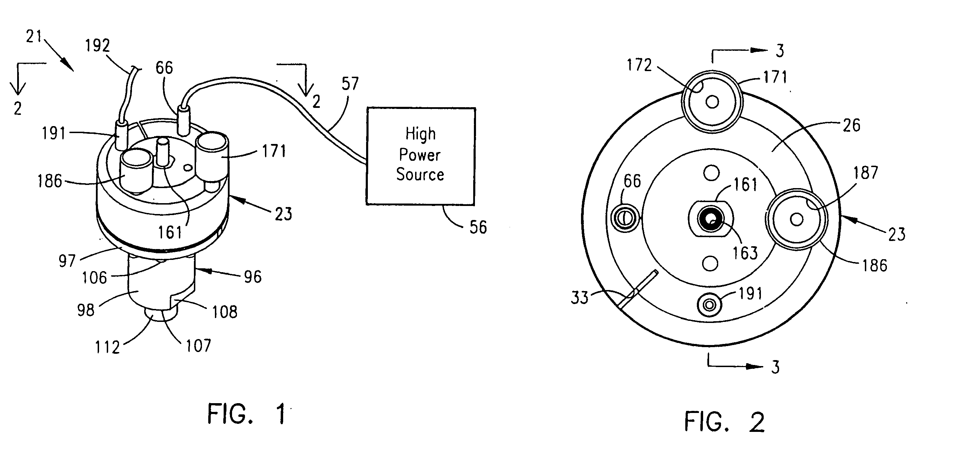

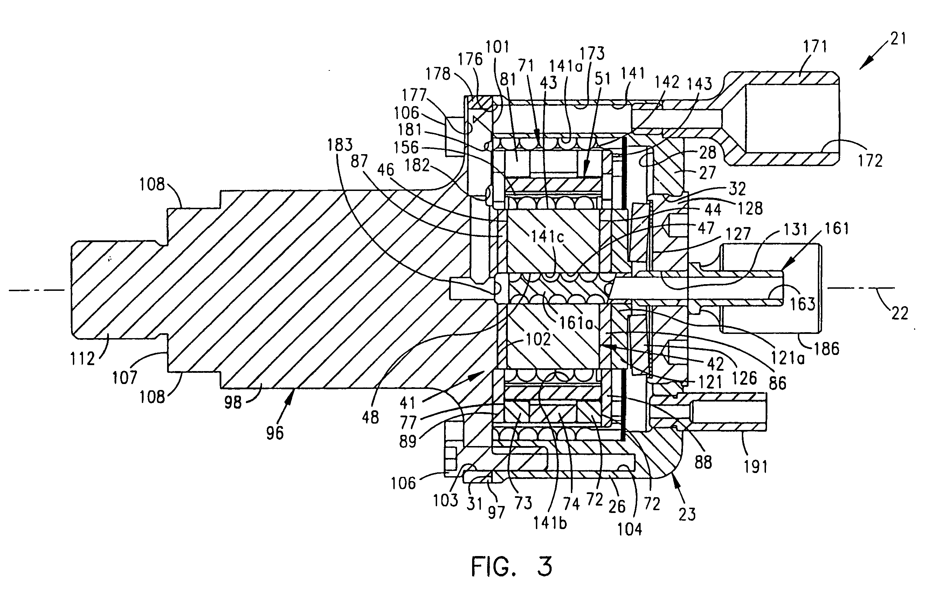

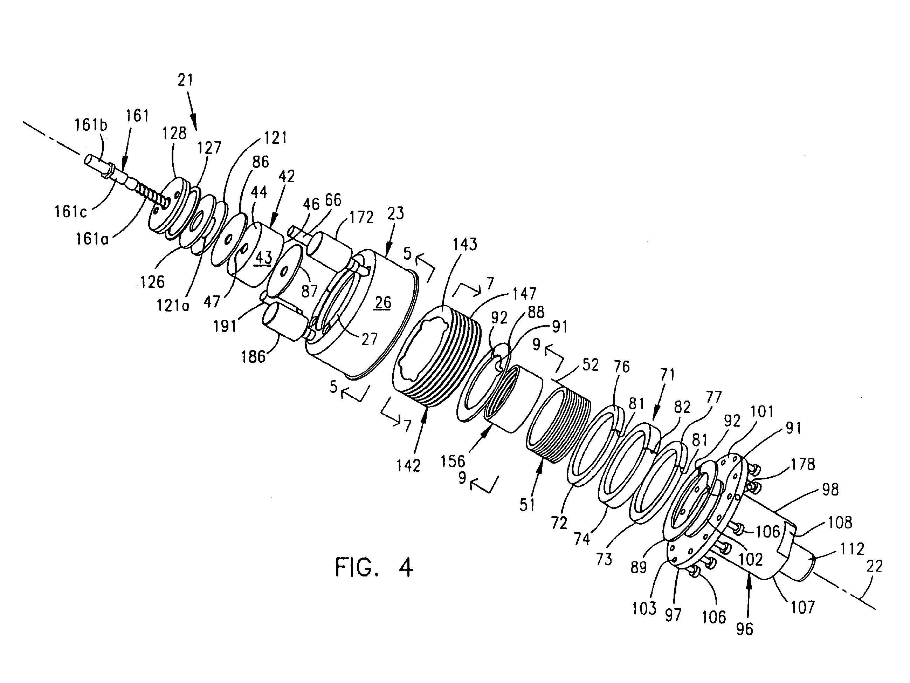

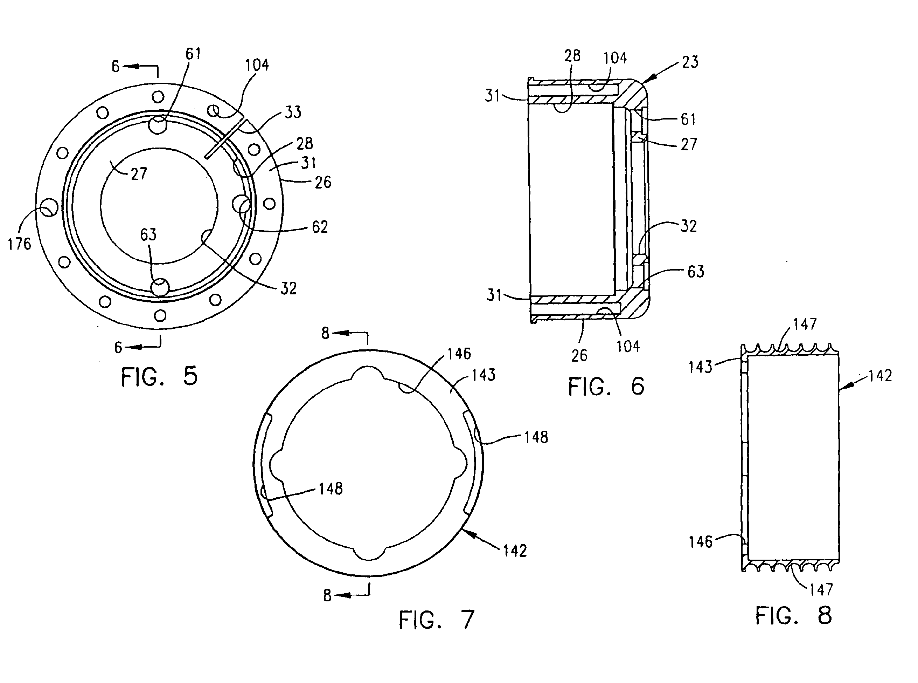

The high power ultrasonic actuator or motor 21 of the present invention is cylindrical in conformation and concentrically disposed about a central longitudinal axis 22 (see Figs. 3 and 4). Apparatus or motor 21 is relatively small in size and has a diameter of approximately 7.6cm (three inches) and a length of approximately 10.2cm (four inches). A housing member or motor housing 23 of predetermined geometry is included within motor 21. Motor housing 23, shown in Figures 1-4 and separately in Figs. 5 and 6, has an outer cylindrical wall 26 which is circular in cross-section and has a generally planar end wall 27 extending across one end of cylindrical wall 26. The other end of cylindrical wall 26 is open for accessing internal chamber 28 of motor housing 23. The internal chamber is formed by walls 26 and 27. The open end of cylindrical wall 26 is provided with an annular planar face 31 extending at a right angle to longitudinal axis 22. A central circular opening 32 extends through end wall 27 into internal chamber 28. Motor housing 23 is made from any suitable material such as 6-2-4-2 titanium. Cylindrical wall 26 has an outer diameter of approximately 7.2cm (2.85 inches) and an inner diameter of approximately 5.8cm (2.3 inches) and a length from end to end of approximately 3.7cm (1.45 inches). End wall 27 has a thickness of approximately 0.6cm (0.25 inch) and central opening 32 has a diameter of approximately 3.8cm (1.5 inches) Motor housing 23 is provided with a radially-extending slit 33 which extends longitudinally through the housing 23 for precluding electrical current from traveling circumferentially around the motor housing. Any such currents in the motor housing produce unwanted electromagnetic fields and heat which disrupt the efficiency of ultrasonic motor 21. Slit 33 has a thickness of approximately 0.1cm (0.04 inch) and extends radially inwardly from the outside of motor housing 23 a distance of approximately 1:5cm (0.60 inch).

A transducer assembly or transducer 41 is carried by motor housing 23 and, more specifically, is disposed within internal chamber 28. Transducer 41, as shown in FIGS. 3 and 4, includes a cylindrical or rod-like member in the form of drive rod 42 made from any suitable active or smart material which changes shape when energized by being placed in an electromagnetic field. Such active materials include magnetostrictive materials which change shape in response to an applied magnetic field. A magnetostrictive material is preferred because such a material can tolerate high mechanical stress so as to have a relatively high energy density. High energy density enables more mechanical power output from a given electrical power input and volume of smart material which thus reduces the size and weight of ultrasonic motor 21. Preferred magnetostrictive materials are rare earth materials and rare earth-transition metal materials. Preferred rare earth-transition metal are rare earth-iron materials of the type disclosed in U.S. Patent Nos. 4,308,474; 4,609,402; 4,770,704; 4,849,034 or 4,818,304 and commonly referred to as TERFENOL-D. TERFENOL-D is a metal alloy formed from the elements terbium, dysprosium and iron and has the formula of TbₓDy₁₋ₓFe_{1.92}. The preferred formula for the TERFENOL-D material of drive rod 42 is Tb₋₃Dy_{.7}Fe_{1.90-1.95}, Magnetostrictive materials such as TERFENOL-D have a desirably wide operating temperature environment ranging from approximately -100 to +380 °C. TERFENOL-D is also advantageous in that it has a relatively high thermal conductivity ranging from 10.5 to 10.8 W/m-K.

Drive rod 42 is formed with an outer cylindrical surface 43 and first and second planar end surfaces 44 and 46 extending perpendicular to longitudinal axis 22 and parallel to each other. Drive red 42 has a diameter of approximately 3.2cm (1.25 inches) and a length between end surfaces 44 and 46 of approximately 1.8cm (0.7 inch). A bore 47 extends along central longitudinal axis 22 between end surfaces 44 and 46 and is formed from an internal cylindrical surface 48 having a diameter of approximately 0.6cm (0.25 inch). Drive rod 42 is laminated to control eddy currents therein.

Transducer 41 includes a drive coil 51 which serves as means for producing an electromagnetic field extending through at least a portion of active drive rod 42 (see FIGS. 3 and 4). Coil 51 is concentrically disposed about drive rod 42 within internal chamber 28 and generates an electromagnetic field which extends through the entire drive rod 42. Coil Si is made from 18 AWG S build square copper wire 52 wound in place with Duralco 128 epoxy made by Cotronics of Brooklyn, New York. The electrically conductive wire 52 has a direct current resistance at 22° C of approximately 0.09 ohms. Coil 51 is wound with two layers of wire 52 and has 17 turns per layer. The wire wound coil 51 has a length of approximately 1.9cm (0.74 inch). an external diameter of approximately 4.3cm (1.7 inches)and an internal diameter of approximately 3.8cm (1.5 inches).

High power source 56 is included within the means of ultrasonic motor 21 for providing an electrical signal to transducer 41 (see FIG. 1). Electrical source 56 provides power in the range from 10 watts to 50 kilowatts to the transducer and preferably in excess of three kilowatts, Power source 56 most preferably provides approximately six kilowatts of power to transducer 41 is the form of an ultrasonic three phase sinusoidal signal of approximately 150 volts and 40 amps. An electrical wire 57, shown for simplicity only in FIG. 1, couples power source 56 to the free end of coil wire 52. End wall 27 of motor housing 23 is provided with first, second and third angularly spaced-apart bores 61, 62 and 63 for communicating with internal chamber 28. (see FIG. 5). The angular spacing between first and second bores 61 and 62 and between second and third bores 62 and 63 is each approximately 90°. A tubular strain relief 66 is disposed at one end in first bore 61. Wire 57 extends from power source 56 through strain relief 66 and first bore 61 and is electrically connected to wire 52.

Magnetic means or tubular magnetic means 71 is provided in ultrasonic motor 21 for continuously biasing drive rod 42 (see FIGS. 3 and 4). The tubular magnetic means 71 has first and second opposite end portions consisting of first and second annular bias magnets 72 and 73 and a centre portions consisting of third or central annular bias magnet 74. Central bias magnet 74 is disposed between first and second bias magnets 72 and 73. The bias magnets 72-74 are made from a hard magnetic material and can be of any suitable type such as many of the different grades of neodymium iron boron magnets. Alternatively, the bias magnets 72-74 can be made from materials such as samarium cobalt.

Tubular magnetic means 71 is sized and shaped to produce a uniform dc magnetic field through drive rod 42. The greater radial thicknesses of first and second bias magnets 72 and 73 relative to the radial thickness of central bias magnet 74 provides such a uniform dc magnetic bias, First and second bias magnets 72 and 73 each have a longitudinal dimension or length of approximately 0.5cm (0.2 inch) and outer and inner diameters of approximately 5.3cm (2.1 inches) and 4.4cm (1.72 inches), respectively, Central bias magnet 74 has a length of approximately 0.9cm (0.35 inch) and outer and inner diameters of approximately 5.3cm (2.1 inches) and 4.5cm (1.79 inches), respectively. As can be seen, central bias magnet 74 has a radial thickness which is less than the radial thickness of first and second bias magnets 72 and 73 resulting from an inner diameter which is greater than the inner diameter of magnets 72 and 73.

As shown in FIG. 3, tubular magnetic means 71 is concentrically disposed about coil 51. Bias magnets 72-74 have an aggregate length closely approximating the length of coil 51. First bias magnet 72 has an outer, planar end surface 76 which is longitudinally aligned with one end surface of coil 51. Second bias magnet 73 has an outer, planar end surface 77 which is longitudinally aligned with the other end surface of coil 51. First and seconde bias magnets 72 and 73 each have a slit 81 with a thickness of approximately 0.1 cm (0.04 inch) extending radially therethrough. Central bias magnet 74 is provided with a slit 82 having a thickness of approximately 0.1 cm (0.04 inch) extending radially therethrough. Slits 81 and 82 are longitudinally aligned and extend in a direction parallel to longitudinal axis 22 for precluding electrical currrents from traveling circumferentially around the bias magnets, As discussed above, such currents can create unwanted magnetic fields and heat which disrupt the desired performance of transducer 41.

First and second flux return means are carried by motor housing 23 within internal chamber 28 for capturing the dc magnetic field created by bias magnets 72-73 and directing this dc field through drive rod 42 (see FIGS. 3 and 4). The first and second flux return means also capture the ac magnetic field generated by coil 51 and channel this ac field into drive rod 42. The first and second flux return means include first and second inner annular disk-like members or magnetic disks 86 and 87 and first and second annular ring members or magnetic rings 88 and 89.

Disks 86 and 87 and rings 88 and 89 are each made from any suitable ferromagnetic or soft magnetic material having a relatively low electrical conductivity and a relatively high electrical resistivity. The flux elements 86-89 also have a relatively high magnetic saturation flux density. It is preferred that the material of elements 86-89 has an electrical resistivity greater than 1000 ohm-cm, although a more practical electrical resistivity range is between 0.01 to 1000 ohm-cm. The minimum resistivity is 0.01ohm-cm. It is preferable that the magnetic saturation flux density be greater than 8 tesla (8,000 gauss) more preferably greater than 12 tesla (12,000 gauss) and most preferably greater than 20 tesla (20,000 gauss).

A suitable material for element 86-89 is the material marketed under the trade name, High Flux by Arnold Engineering of Marengo, Illinois and Magnetics of Butler, Pennsylvania. High Flux is a nickel and iron alloy having the composition of .5 nicker and the balance iron. The nickel and iron elements of the High Flux material are ground into micron and sub-micron particle sizes. A dielectric is sprayed on the particles to electrically insulate them and that powder mix is compressed at roughly 2758 MN/m2 (200 tons per square inch) to make a solid component which is the equivalent of a sandstone structure. Another suitable material is iron powder marketed by MMG-North America of Paterson, New Jersey. The iron powder has a composition of greater than 95% iron. The iron powder is produced in a manner similar to the method for producing High Flux described above. Briefly, the iron elements are ground into micron and sub-micron particle sizes. A dielectric is sprayed on the particles to electrically insulate them and that powder mix is compressed to make a solid component which is the equivalent of a sandstone structure. Each of these materials has an electrical resistivity ranging from 0.01 to 50 ohm-cm and a magnetic saturation flux density ranging from 12 to 15 tesla (12,000 to 15,000 gauss). High flux has a high relative permeability which makes it a better magnetic flux conductor.

First magnetic disk 86 has a longitudinal dimension or thickness of approximately 0.25cm (0.1 inch) and outer and inner diameters of approximately 3.2cm (1.255 inches) and 0.64cm (0.25 inch), respectively. Second magnetic disk 87 has a longitudinal dimension or thickness of approximately 0.18cm (0.07 inch) and outer and inner diameters of approximately 3.2cm (1.255 inches) and 0.64cm (0.25 inch), respectively. Disks 86 and 87 are each centered on longitudinal axis 22 with first magnetic disk 86 abutting first end surface 44 of drive rod 42 and second magnetic disk 87 abutting the second end surface 46 of the drive rod 42.

First and second magnetic rings 88 and 89 each have a longitudinal dimension or thickness of approximately 0.20cm (0.08 inch) and outer and inner diameters of approximately 5.3cm (2.095 inches) 3.3cm (1.31 inch), respectively. Each of the rings 88 and 89 is provided with a cutout 91 in the shape of a half-moon on the inside thereof and a radially-extending slit 92 extending therethrough and having a thickness of approximately 0.30cm (0.12 inch). Cutout 91 in first ring 88 permits coil wire 52 to pass ring 88 and exit internal chamber 28 for electrical coupling to wire 57 and thus power source 56. Slits 92 preclude electrical currents from traveling circumferentially around the rings 88 and 89 for the same reasons discussed above with respect to slits 33, 81 and 82. The first magnetic ring 88 abuts end surface 76 of first bias magnet 72 and the corresponding end of coil 51 and the second magnetic ring 89 abuts end surface 77 of the second bias magnet 73 and the corresponding end of coil 51.

An acoustic element or extension 96 is included within ultrasonic motor 21 and, among other things, serves to close the open end of motor housing 23. As shown most clearly in FIGS. 3 and 4, acoustic extension 96 includes a flange portion 97 and a cylindrical portion 98 each of which are centered on longitudinal axis 22. Disk-like flange portion 97 has a longitudinal dimensional or thickness of approximately 0.57cm (0.225 inch) and an external diameter of approximately 7.4cm (2.9 inches). The flange portion 97 has a generally planar surface or face 101 which abuts and mates with annular planar face 31 of motor housing 23. A central planar surface 102 is provided at the center of face 101. Central surface 102 has an outer diameter of approximately, 3.2cm (1.255 inches) and is parallel to face 101. Central surface 102 is spaced outwardly from face 101 a distance of approximately 0.089cm (0.035 inch). A plurality of 12 circumferentially spaced-apart bores 103 extend longitudinally through flange portion 97 and longitudinally align with an equal plurality of threaded bores 104 extending longitudinally into planar face 31 of motor housing 23. A cap screw 106 extends through each of flange bores 103 and threadably engages a bore 104 in the motor housing to secure the acoustic extension 96 to motor housing 23.

Cylindrical portion 98 is integral with flange portion 97 and extends from the flange portion 97 in a direction away from face 101. An annular planar surface 107 extending parallel to face 101 forms the other end of acoustic extension 96. Two oppositely aligned cutouts or flats 108 are formed in cylindrical portion 98 adjacent end surface 107 for facilitating gripping and rotating of ultransonic motor 21 with a wrench. A threaded stub 112 protrudes perpendicularly from end surface 107 a distance of approximately1.8cm (0.7 inch).

Acoustic extension 96 is made from any suitable material such as an acoustic metal. Suitable acoustic metals are aluminum alloys, magnesium alloys and titanium alloys. A magnesium alloy is preferred for the material of acoustic extension 96. Preferred magnesium alloys for forming acoustic extension 96 are high Q/low damping materials and include materials being of the following American Society for Testing and Materials (ASTM) type: AZ31B-F° and AZ31B-H24 each having percentage compositions of aluminum, zinc and magnesium ranging from 2.5 to 3.5, 0.7 to 1.3 and at least 0.20, respectively; AZ61A-F having percentage compositions of aluminum, zinc and magnesium ranging from 5.8 to 7.2, 0.4 to 1.5 and at least 0.15, respectively; AZ80A-T5 having percentage compositions of aluminum, zinc and magnesium ranging from 7.8 to 9.2, 0.2 to 0.8 and at least 0.15, respectively; ZK60A-T5 having percentage compositions of zinc and zirconium ranging from 4.8 to 6.2 and at least 0.45, respectively; and HK31A-H24 having percentage compositions of thorium and zirconium ranging from 2.5 to 4.0 and 0.45 to 1.0, respectively. These materials each have a Q (quality factor) which is greater than 100 and a high fatigue strength ranging from 124 to 207 MN/m² (18,000 to 30,000 psi). ZK60A-T5, AZ31B and AZ61A-F are more preferable materials for acoustic extension 96 and AZ80A-T5 is most preferable because it has a relatively high electrical resistivity of approximately 12.2 µohm-cm.

Acoustic extension has a longitudinal dimension or length measured from central face 1102 to end surface 107 of approximately 6.4cm (2.5 inches), which is equal to the quarter resonant wavelength of the material of the acoustic extension. Accordingly, the acoustic extension is sized to vibrate from transducer 41 at its resonant frequency.

The stack of second magnetic disk 87, drive rod 42 and first magnetic disk 86 are disposed in internal chamber 28 (see FIG. 3). Second magnetic disk 87 abuts central surface 102. Coil 51 extends aground drive rod 42 and is stacked between first and second magnetic rings 88 and 89. The second magnetic ring 89 abuts face 101 of flange portion 97. First bias magnet 72, central bias magnet 74 and second bias magnet 73 are stacked between first and second magnetic rings 88 and 89 outside coil 51. A disk-like reaction mass 121 centered along longitudinal axis 22 abuts first magnetic disk 86. Reaction mass 121 is made from any suitable material such as 17-4 PH stainless steel and has a longitudinal dimension or thickness of approximately 0.25cm (0.1 inch) and outer and inner diameters of approximately 3.2cm (1.225 inches) and 0.62cm (0.245 inch), respectively. The reaction mass 121 has a raised central portion 121a with a diameter of approximately, 1.1 cm (0.45 inch).

The central portion 121a has a longitudinal dimension or thickness of approximately 0.10cm (0.04 inch).

The reaction mass 121 is sized with a specific mass so that the combined mass of the reaction mass 121 and first magnetic disk 86 make drive rod 42 operate at its resonant frequency.

Means is included within ultrasonic motor 21 for imparting a preload on drive rod 42 and includes a belleville spring 126, a preload disk 127 and a preload plate 128. Belleville spring 126 can be of any suitable type such as part number BEL-2401-2410 made by HK Metalcraft of Lodi, New Jersey. Preload disk 127, which precludes the belleville spring 126 from embedding within preload plate 128, can be made from any suitable material such as 1.95 blue hardened spring steel. The disk 127 has a longitudinal dimension or thickness of approximately 0.076cm (0.03 inch) and outer and inner diameters of approximately 3.5cm (1.4 inches) and 2.5cm (1.0 inch), respectively. Preload plate 128 is disk-like in shape and made from any suitable material such as 6-2-4-2 titanium. Preload plate 128 has an outer cylindrical surface which is treaded and diametrically sized to threadably engage central opening 32 of motor housing 23. A threaded bore 131 extends through the center of preload plate 128. Preload plate 128 is rotatably tightened within central opening 32 so as to provide a preload on drive rod 42 ranging from 680 to 1270 Kg (1500 to 2800 Ibs) and preferably approximately 1043 Kg (2300 Ibs).

Active cooling means is provided in ultrasonic motor 21 for extending the duty cycle of the motor 21 and enhancing the performance thereof. The active cooling means includes a fluid passageway 141 having portions extending about drive rod 42, coil 51 and tubular magnetic means 71. Fluid passageway 141 is adapted to permit any suitable dielectric cooling fluid to flow through ultrasonic motor 21 for cooling transducer 41 and other motor components. Any synthetic heat transfer fluid, such as the fluid having the trade name Multitherm 503 made by Multitherm Corporation of Colwyn, Pennsylvania, is a suitable cooling fluid for ultrasonic motor 21.

Fuid passageway 141 has three helical portions consisting of first or outer helical portion 141a, second or middle helical portion 141b and third or central helical portion 141c. Outer helical portion 141a, as shown in FIG. 3, extends circumferentially around the outside of tubular magnetic means 71 and is formed in part by the inner surface of cylindrical wall 26. Outer helical portion 141a is further formed by a tubular member consisting of outer cooling fixture 142, illustrated separately in FIGS. 7 and 8, which extends around the tubular magnetic means 71. Cooling fixture 142 has a longitudinal dimension or length of approximately 2.5cm (0.99 inch) and outer and inner diameters of approximately 5.8cm (2.298 inches) and 5.3cm (2.1 inches), respectively. A disk-like ring 143 is formed at one end of the cooling fixture 142. Ring 143 is provided with a central opening 146 having an internal diameter of approximately 4.4 cm (1.75 inches). The outer cylindrical surface of cooling fixture 142 is formed with a helical channel 147 provided with at least six turns (see FIGS. 4 and 8). Channel 147 has a radius of approximately 0.15cm (0.06 inch). Two diametrically opposed cutouts 148 are provided in ring 143 for communicating with helical channel 147. Outer cooling fixture 142 is disposed in internal chamber 28 so that ring 143 is positioned close to end wall 27 of motor housing 23.

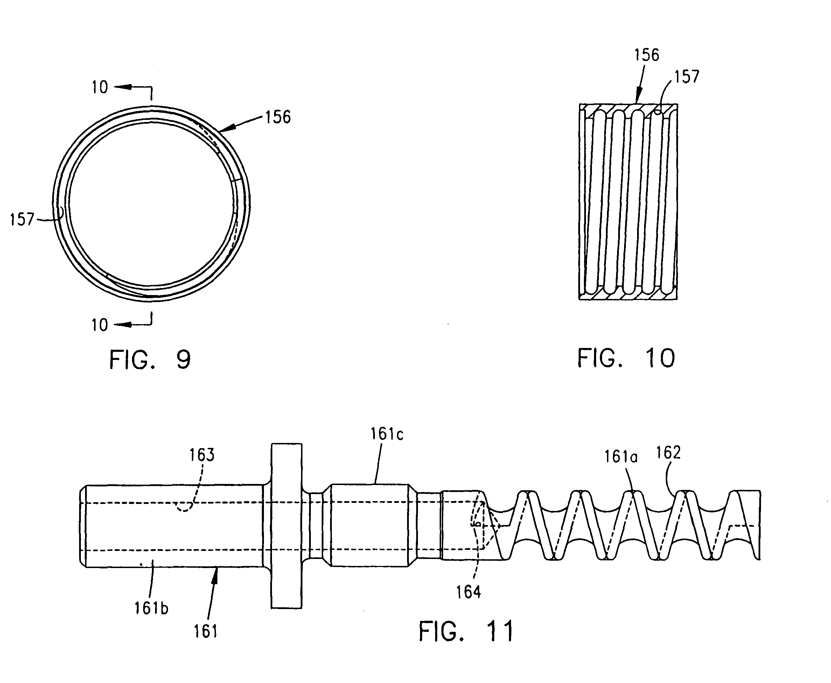

Ultrasonic motor 21 has means which includes a second tubular member or cooling fixture 156 for forming middle helical portion 141b of fluid passageway 141. Cooling fixture or inner cooling fixture 156, as shown separately in FIGS. 9 and 10, has a longitudinal dimension or length of approximately 1.9cm (0.74 inch) and outer and inner diameters of approximately 3.8cm (1.5 inches) and 3.2cm (1.26 inches), respectively. The inner cylindrical surface of cooling fixture 156 is formed with a helical channel 157 having at least five turns. Channel 157 has a radius of approximately 0.15cm (0.06 inch). As shown in FIG. 3, inner cooling fixture 156 is disposed between drive coil 51 and drive rod 42. Outer cylindrical surface 43 of the drive rod 42 forms the inner surface of middle helical portion 141b of the fluid passageway 141.

Outer and inner cooling fixtures 142 and 156 are each made from an electrically insulating or nonconductive material. Suitable materials are ceramics such as boron nitride, alumina, silicon carbide, boron carbide, titanium diboride, tungsten carbide, silicon nitride, spinel, pyrolitic boron nitride, and beryllia, including all compositions, variations and grades of the foregoing. Another suitable material is aluminum nitride. The preferred material of the cooling fixtures 142 and 156 is hot pressed boron nitride. The aforementioned materials are good thermal conductors and thus enhance the removal of heat from motor housing 23 and the components therein. Specifically, the materials have a relatively high thermal conductivity of greater than 1 W/m-K and preferably greater than 30 W/m-K.

Central helical portion 141c extends through central bore 47 of drive rod 42. Means for forming central helical portion 141c includes an elongate member in the form of cooling tube 161. Inner cylindrical surface 48 of the drive rod also serves to form the central helical portion 141c of fluid passageway 141. Cooling tube 161 is made from any suitable nonelectrically conducting material such as a polyamide/imide, for example Torion, and has a first end portion or helical portion 161a and an opposite second end portion in the form of fitting 161b (see FIG. 11). A central or threaded portion 161c is disposed between helical portion 161a and fitting 161b. Helical portion 161a is sized and shaped for disposition within drive rod bore 47, as shown in FIG. 3, and has a longitudinal dimension or length of approximately 1.9cm (0.75 inch) and an outer diameter of approximately 0.53cm (0.21 inch). A helical channel 162 having at least four turns extends circumferentially around helical portion 161a. The helical channel 162 has a radius of approximately 0.15cm (0.06 inch). Cylindrical central portion 161c of cooling tube 161 is externally sized and shaped to threadably engage threaded bore 131 of preload plate 128 to secure helical portion 161a within drive rod 42. A central bore 163 extends longitudinally through fitting 161b and central portion 161c to an opening 164 in helical channel 162 (see FIG. 11). Bore 163 extends through the open end of fitting 161b.

The cooling fluid is introduced into ultrasonic motor 21 by means of a tubular inlet fitting 171 having a bore 172 extending therethrough (see FIGS. 1-4). An inlet line (not shown) is connected to fitting 171 in this regard. Inlet fitting 171 is threadably secured to an inlet bore 173 extending longitudinally through cylindrical wall 26 of motor housing 23 (see FIGS. 3 and 5). Longitudinal inlet bore 173 communicates by means of an opening 176 in flange face 101 with a radially-extending bore 177 entering the side of flange portion 97 of acoustic extension 96. Radial bore 177 extends approximately to the center of flange portion 97. A plug 178 serves to close the opening of radial bore 177 in the outer cylindrical surface of flange portion 97. First, second and third openings 181, 182 and 183 further extend through flange face 101 for communicating with transverse bore 177 (see FIGS. 3 and 4). First opening 181 is radially positioned on flange face 101 so as to permit fluid within radial bore 177 to communicate with outer helical portion 141a of fluid passageway 141. Second and third openings 182 and 183 are similarly positioned to permit cooling fluid to access middle and central helical portions 141b and 141c of the fluid passageway. Cutouts 91 facilitate the flow of the cooling fluid past the first and second magnetic rings 88 and 89.

The cooling fluid flowing through outer end middle helical portions 141a and 141b of the fluid passageway 141 recombines in internal chamber 28 at the other longitudinal ends of outer and inner cooling fixtures 142 and 156. The fluid within outer cooling fixture 142 exits outer helical portion 141a by means of cutouts 148 in this regard. The cooling fluid from passageway portions 141a and 141b exits motor housing 23 through third bore 63 in end wall 27. A tubular member in the form of outlet fitting 186 extends longitudinally from motor housing 23 and is provided with a bore 187 in communication with third bore 63. The cooling fluid traveling through central helical portion 141c of fluid passageway 141 enters central bore 163 in cooling tube 161 through opening 164 to exit ultrasonic motor 21 means of the cooling tube. Exit lines (not shown) are secured to outlet fitting 196 and fitting 161b of the cooling tube 161 for carrying the cooling fluid away from ultrasonic motor 21.

The temperature within internal chamber 28 can be monitored by means of any suitable temperature sensor (not shown) such as a thermistor or thermocouple disposed in slit 92 in first magnetic ring 88 atop drive coil 51. A tubular strain relief 191 is secured to motor housing 23 and communicates with second bore 62 for permitting an electrical wire 192 to enter the motor housing for connection to the temperature sensor.

In operation and use, motor 21 uses a drive rod made from a magnetostrictive material such as TERFENOL-D to produce vibratory motion at threaded stub 112 of acoustic extension 96. This vibratory motion is in the ultrasonic frequency range, that is, greater than 17 kilohertz. In general, drive rod 42 is changeable between a first shape in the absence of a magnetic field and a second shape when in the presence of a magnetic field. More specifically, the magnetic domains in the giant magnetostrictive material of the drive rod 42 align with longitudinal axis 22 when a magnetic field parallel to axis 22 is applied to the drive rod. This alignment of the magnetic domains causes the drive rod 42 to elongate. A sinusoidal input signal is provided to coil 51 for producing a changing electromagnetic field which has the same frequency as the input signal and extends through the drive rod 42.

Belleville spring 126 serves to create a longitudinal preload on drive rod 42 which remains constant at approximately 1043 Kg (2300 lbs) throughout the actuation and deactuation of the drive rod 42. The preload externally causes the magnetic domains to be more perfectly oriented perpendicular to the longitudinal axis 22 of drive rod 42. A much lounger linear operation region on the strain versus magnetic field strength curve for the drive rod is thus provided resulting in a much higher strain for a magnetic field of given strength in comparison to a drive rod having no prestress thereon.

Tubular magnetic means 71 provides a dc magnetic bias to drive rod 42 which causes the magnetic domains within the drive rod to strain to roughly one-half of their maximum possible value. With the material of drive rod 42 now at one-half of its total strain, the ac magnetic field from coil 51 adds to and subtracts from the dc magnetic bias field which, through magnetostriction, causes the drive rod 42 to expand and contract from its magnetically biased strain. The magnetic biasing of drive rod 42 increases the overall efficiency of the magnetostrictive material of the drive rod and decreases the required strength of the input signal to drive coil 51 and the resulting heat generated by the drive coil by a factor of two.

The sizing and shaping of tubular magnetic means 71 provides for a dc magnetic bias in drive rod 42 which is substantially uniform. As discussed above, the radial thickness of central. bias magnet 74 is smaller than the radial thickness of first and second bias magnets 72 and 73 disposed on either side of the central bias magnet. This thickness reduction is caused by the relatively larger inner diameter of central bias magnet 74. The relatively thinner central bias magnet 74 reduces the intensity of the dc magnetic bias field at the longitudinal center of drive rod 42. The uniform dc bias from tubular magnetic means 71 enhances the performance of drive rod 42 and the magnetic coupling of the drive rod to drive coil 51.

The substantially uniform magnetic bias through drive rod 42 is further facilitated by the use of flux return elements 86-89. As discussed above, first and second magnetic disks 86 and 87 are disposed on respective end surfaces 44 and 46 of drive rod 42. First and second magnetic rings 88 and 89 are disposed on respective end surfaces 76 and 77 of the tubular magnetic means 71. These flux return elements serve to capture the dc magnetic field generated by bias magnets 72-74 and direct the field through drive rod 42 thereby reducing magnetic flux leakage in the drive rod 42 and thus enhancing the dc biasing of the drive rod.

The sinusoidal input signal provided by power source 56 to ultrasonic motor 21 has a power of approximately six kilowatts and a frequency of approximately 20 kilohertz. The input signal passes through helically wound wire 52 of drive coil 51 and causes an alternating electromagnetic field to be generated by the coil through drive rod 42. This magnetic field has a maximum field strength ranging from -150/π × 10³ Am⁻¹ to 150/π × 10³ Am⁻¹ (-600 to +600 oersted) and preferably approximately 125/π × 10³ Am⁻¹ (500 oersted). The magnetic domains in the magnetostrictive material of drive rod 42 respond to the induced magnetic field by straining, causing the length of the drive rod to elongate and contract in phase with the frequency of the induced magnetic field generated by drive coil 51.

Ultrasonic motor 21 operates on the principle of conservation of momentum. Motor housing 23 and transducer 41 and the other components therein constitute the motor section of the apparatus 21. Acoustic extension 96 serves as the momentum reactionary section of the apparatus 21. The oscillatory movement of drive rod 42 causes a corresponding oscillatory force to be exerted by the drive rod 42 against reaction mass 121. As the reaction mass is driven in one direction against belleville spring 126, acoustic extension 96 must respond in an opposite direction to conserve momentum. The longitudinal velocity of ultrasonic motor 21 at flange face 101 is approximately zero. The maximum longitudinal velocity of the motor 21 is at end surface 107. The acoustic extension 96 is in the direct load path of drive rod 42 and, as discussed above, is longitudinally sized so as to operate at its resonant frequency. Accordingly, a resonant one-half wavelength standing wave is established to cause threaded stub 112 to oscillate at an ultrasonic frequency in response to transducer 41. The established standing wave is 180° out of phase with the oscillating drive rod 42. Stub 112 can be attached to other systems to produce usable work.

The formation of acoustic extension 96 from the various magnesium alloys set forth above enhances the ultrasonic vibratory motion produced by acoustic extension 96. In general, these magnesium alloys have relatively low density and thus, in accordance with the conservation of momentum principle, increase the velocity of the vibration amplitude output at threaded stub 112 relative to other acoustic metals such as titanium alloys. The magnesium alloy material of extension 96 also has relatively high strength which contributes to the life of motor 21.

The flux return elements 86-89 also serve to capture the ac magnetic field created by drive coil 51 and channel that field through drive rod 42 so as to increase the ac magnetic field intensity in the drive rod and thus enhance the performance of transducer 41. The magnetic rings 88 and 89 are positioned at the longitudinal ends of drive coil 51 and the magnetic disks 86 and 87 are positioned at the longitudinal ends of drive rod 42 for this purpose. As discussed above, disks 86 and 87 and rings 88 and 89 are each made from soft magnetic materials which have low electrical conductivity. These elements are ferromagnetic at ultrasonic frequencies and have very low energy losses. The relatively high electrical resistivity of these elements precludes the creation of appreciable eddy currents therein which reduce the ability of the flux return elements to conduct and direct magnetic flux. Such eddy currents also disrupt the intensity of the alternating magnetic field through the drive rod 42 and thus negatively affect the efficiency of transducer 41. The capturing and redirecting of the ac magnetic field by flux return elements 86-89 serves to increase the efficiency of ultrasonic motor 21 by a factor of two to five.

The active cooling of transducer 41 and tubular magnetic means 71 within ultrasonic motor 21 by means of fluid passageway 141 further enhances the performance of the motor. The active cooling also permits continuous operation of ultrasonic motor 21 at full power. The incorporation of helical passageway portions in and around drive rod 42, drive coil 51 and bias magnets 72-74 increases the ability of the cooling fluid to carry heat away from the motor. In this regard, the utilization of helical channels 147, 157 and 162 increases the heat transfer area encountered by the cooling fluid. Helical portions 141a-c increase the fluid flow speed in and around transducer 41 to enhance chaotic flow patterns and turbulence and thus further increase the convection coefficient of the cooling fluid. Specifically, the velocity and convection coefficient of the cooling fluid through helical portions 141a-c are increased approximately 10 times and 45 times, respectively.

The construction of outer and inner cooling fixtures 142 and 156 from an electrically insulating or dielectric material further serves to enhance the operating efficiency of transducer 41. Deleterious eddy currents from the high frequency magnetic field generated by drive coil 51 are not produced in cooling fixtures 142 and 156. Eddy currents can disrupt the intensity of the ac magnetic field extending through drive rod 42. Such undesirable eddy currents are also not generated in the nonconductive cooling fluid of ultrasonic motor 21. In addition, fixtures 142 and 156 are good heat conductors and thus enhance the transfer of heat from the various components in the motor section of ultrasonic motor 21 to the cooling fluid. The dielectric material of cooling fixtures 142 and 156 further protects against electrical shorts within motor 21.

The ultrasonic energy generated by motor 21 can produce usable work in many applications. For example, ultrasonic motor 21 can be used for the excitation of solids, fluids and gases. In the excitation of chemical mixtures, motor 21 can cause physical, structural and chemical changes in the mixture. As an example, motor 21 can be used for the curing of polymers such as industrial epoxy or for the devulcanization of rubber. Motor 21 can be easily scaled larger or smaller for use in other applications. For example, a smaller motor could be used for various surgical or other medical tools. Examples include medical tools for dental cleaning, bone prosthesis insertion and removal, sonic imaging and surgery. Other applications include using motor 21 for disrupting biological cells. Motor 21 can further be used for degassing soda pop, beer or wine, for ultrasonically machining materials or welding components together and for sonicating seed.

In an alternative design of the high power ultrasonic motor of the present invention, the transducer can be operated in quarter-wave mode wherein one end of the motor section is fixed and the other end of the motor section is free to move. In this design, no acoustic extension is needed. In other embodiments, less effective flux concentrating soft magnetic materials such as ferrites or molybdenum permalloy powder can be used in place of the materials of the high flux return elements described above and be within the scope of the present invention. It should also be appreciated that other embodiments of the ultrasonic motor herein can include less than all of the components described above and be within the scope of the present invention. In addition, transducers utilizing some or all of the features described above can be provided for use in applicators other than ultrasonics and be within the scope of the present invention.

From the foregoing, it can be seen that a new and improved ultrasonic motor has been provided. The ultrasonic motor utilizes a smart material actuation element made from a magnetostrictive material such as TERFENOL-D and has a momentum reactionary section made from a material of relatively low density. Reliable and continuous high power in excess of three kilowatts can be generated by the motor. The motor is relatively compact in size and is easily scalable. Active cooling with a dielectric fluid can be provided. The actuation element can be magnetically biased with a substantially uniform dc magnetic field and flux return elements made from a low electrical conductivity material can be utilized. A displacement at the wave guide tip of approximately 20 micrometers peak-to-peak can be generated. The motor can provide a pressure on the wave guide face of approximately 1134 Kg (2500 psi).

## Claims

1. An ultrasonic motor (21) capable of generating a power in excess of three kilowatts comprising a housing (23) having a predetermined geometry, a transducer (41) having an active element (42) made from a giant magnetostrictive material, a cooling means (141) for cooling the active element (42) and means (51) for producing an electromagnetic field which extends through at least a portion of the active element (42), the active element (42) changeable between a first shape when in the absence of the electromagnetic field and a second shape when in the presence of the electromagnetic field, biasing means for biasing the active element (42), flux return means (86,87, 88, 89) made from a material having an electrical resistivity of at least 0.01 ohm-cm for capturing magnetic flux produced by the means (51) for producing an electromagnetic field, and channelling that flux through the active element (42), means (56) for providing an electrical signal to the means (51) for producing an electromagnetic field and an acoustic element (96) connected to the transducer (41) for providing ultrasonic energy to perform work.

2. The ultrasonic motor (21) of claim 1 wherein the active element is a cylindrical element (42) and wherein the means for producing an electromagnetic field is a coil (51) made from a conductive material concentrically disposed about the cylindrical element (42).

3. The ultrasonic motor (21) of claim 2 wherein the biasing means is a magnetic means.

4. The ultrasonic motor (21) of claim 2 wherein the magnetic means includes tubular magnetic means (71) concentrically disposed about the cylindrical element (42).

5. The ultrasonic motor (21) of claim 2 wherein the cylindrical element (42) has first and second opposite ends (44, 46) further wherein the flux return means comprises first and second flux return elements (86, 87) carried by the housing (23), the first and second flux return elements (86, 87) located adjacent to the first and second ends (44), (46) of the cylindrical element (42).

6. The ultrasonic motor (21) of claim 5 wherein the first and second flux return elements (86, 87) are first and second disk-like elements.

7. The ultrasonic motor (21) of claim 1 wherein the acoustic element (96) is mounted on the transducer (41) and is made from a material having a quarter resonant wavelength, the acoustic element (96) having a length equal to the quarter resonant wavelength of the material.

8. The ultrasonic motor (21) of claim 1 wherein the acoustic element (96) is made from an acoustic metal.

9. The ultrasonic motor (21) of claim 8 wherein the acoustic metal is a magnesium alloy.

10. The ultrasonic motor (21) of claim 1 wherein the cooling means comprises a passageway (141) within or about the transducer (41) adapted to receive a cooling fluid, the passageway (141) formed from a material which is an electrical insulator.

11. The ultrasonic motor (21) of claim 10 wherein the material has a thermal conductivity greater than about 1 W/m-K.

12. The ultrasonic motor (21) of clam 10 wherein the passageway (141) is formed from hot pressed boron nitride.

13. The ultrasonic motor (21) of claim 10 wherein the passageway (141) is formed from a ceramic material.

14. The ultrasonic motor (21) of claim 10 wherein the passageway (141) is a fluid-carrying helical passageway (141 a,b,c) made from a material selected from the group consisting of boron nitride, aluminium nitride, alumina, silicon carbide, boron carbide, titanium diboride, tungsten carbide, silicon nitride, spinel, and pyrolitic boron nitride beryllia.

15. The ultrasonic motor (21) of claim 14 wherein the fluid-carrying helical passageway (141 a, b, c) extends about the transducer (41).

16. The ultrasonic motor (21) of claim 15 wherein the fluid-carrying helical passageway (141 a, b, c) extends between the cylindrical element (42) and the coil (51).

17. The ultrasonic motor (21) of claim 15 wherein the fluid-carrying helical passageway (141 a, b, c) extends through the cylindrical element (42).

18. The ultrasonic motor (21) according to any preceding claim, wherein the giant magnetostrictive material is TERFENOL-D.

19. The ultrasonic motor (21) according to any preceding claim wherein the ultrasonic transducer (41) is capable of operating continuously at full power.

20. The ultrasonic motor (21) of claim 1 wherein the flux return means material has a magnetic saturation flux density of greater than 8 tesla (8,000 gauss).

## Patentansprüche

1. Ultraschall-Motor (21), der in der Lage ist, mehr als drei Kilowatt Leistung zu erzeugen, umfassend
ein eine vorbestimmte Geometrie aufweisendes Gehäuse (23), einen Transducer (41), der ein aus einem riesig-magnetostriktiven Material hergestelltes aktives Element (42) aufweist,
ein Kühlmittel (141) zum Kühlen des aktiven Elements (42) und Mittel (51) zum Erzeugen eines elektromagnetischen Feldes, das sich durch wenigstens einen Abschnitt des aktiven Elements (42) erstreckt,
wobei das aktive Element (42) änderbar ist zwischen einer ersten Form in Abwesenheit des elektromagnetischen Feldes und einer zweiten Form in Anwesenheit des elektromagnetischen Feldes, Vorspannungsmittel zum Vorspannen des aktiven Elements (42), Fluss-Rückführungsmittel (86, 87, 88, 89), die aus einem Material hergestellt sind, das einen elektrischen Widerstand von wenigstens 0,01 Ohm cm aufweist, zum Einfangen von magnetischem Fluss, der durch die Mittel (51) zum Erzeugen eines elektromagnetischen Feldes erzeugt wird, und zum Kanalisieren dieses Flusses durch das aktive Element (42),
Mittel (56) zum Bereitstellen eines elektrischen Signals an die Mittel (51) zum Erzeugen eines elektromagnetischen Feldes, und
ein akustisches Element (96), das mit dem Transducer (41) zum Bereitstellen von Ultraschall-Energie, um Arbeit zu leisten, verbunden ist.

2. Ultraschall-Motor (21) nach Anspruch 1,
wobei das aktive Element ein zylindrisches Element (42) ist und
wobei die Mittel zum Erzeugen eines elektromagnetischen Feldes eine Spule (51) sind, die aus einem leitfähigen Material hergestellt ist, das konzentrisch um das zylindrische Element (42) angeordnet ist.

3. Ultraschall-Motor (21) nach Anspruch 2,
wobei die Vorspann-Mittel magnetische Mittel sind.

4. Ultraschall-Motor (21) nach Anspruch 2,
wobei die magnetischen Mittel röhrenförmige magnetische Mittel (71) umfassen, die konzentrisch um das zylindrische Element (42) angeordnet sind.

5. Ultraschall-Motor (21) nach Anspruch 2,
wobei das zylindrische Element (42) erste und zweite gegenüberliegende Enden (44, 46) aufweist, und
wobei die Fluss-Rückführungsmittel erste und zweite Fluss-Rückführungselemente (86, 87) umfassen, die durch das Gehäuse (23) getragen sind,
wobei das erste und zweite Fluss-Rückführungselement (86, 87) benachbart zu dem ersten und zweiten Ende (44, 46) des zylindrischen Elements (42) angeordnet sind.

6. Ultraschall-Motor (21) nach Anspruch 5,
wobei das erste und zweite Fluss-Rückführungselement (86, 87) erste und zweite scheibenartige Elemente sind.

7. Ultraschall-Motor (21) nach Anspruch 1,
wobei das akustische Element (96) auf dem Transducer (41) angebracht ist und aus einem Material hergestellt ist, das ein Viertel der Resonanz-Wellenlänge aufweist,
wobei das akustische Element (96) eine Länge gleich dem Viertel der Resonanz-Wellenlänge des Materials aufweist.

8. Ultraschall-Motor (21) nach Anspruch 1,
wobei das akustische Element (96) aus einem akustischen Material hergestellt ist.

9. Ultraschall-Motor (21) nach Anspruch 8,
wobei das akustische Material eine Magnesium-Legierung ist.

10. Ultraschall-Motor (21) nach Anspruch 1,
wobei die Kühlmittel einen Durchgang (141) innerhalb oder über dem Transducer (41) umfassen, der dafür angepasst ist, eine Kühlflüssigkeit aufzunehmen,
wobei der Durchgang (141) aus einem Material gebildet ist, der ein elektrischer Isolator ist.

11. Ultraschall-Motor (21) nach Anspruch 10,
wobei das Material eine thermische Leitfähigkeit aufweist, die größer als ca. 1 W/(m*K) ist.

12. Ultraschall-Motor (21) nach Anspruch 10,
wobei der Durchgang (141) aus heißgepresstem Bornitrid gebildet ist.

13. Ultraschall-Motor (21) nach Anspruch 10,
wobei der Durchgang (141) aus einem keramischen Material gebildet ist.

14. Ultraschall-Motor (21) nach Anspruch 10,
wobei der Durchgang (141) ein fluidtragender wendelförmiger Durchgang (141 a, b, c) ist, der aus einem Material hergestellt ist, das aus der Gruppe ausgewählt ist, die aus Bornitrid, Aluminiumnitrid, Aluminiumoxid, Siliziumkarbid, Borkarbid, Titaniumdiborid, Wolframkarbid, Siliziumnitrid, Spinell, pyrolitischem Bornitrid und Berylliumoxid besteht.

15. Ultraschall-Motor (21) nach Anspruch 14, wobei der fluiddtragende wendelförmige Durchgang (141 a, b, c) sich über dem Transducer (41) erstreckt.

16. Ultraschall-Motor (21) nach Anspruch 15,
wobei sich der fluidtragende wendelförmige Durchgang (141 a, b, c) zwischen dem zylindrischen Element (42) und der Spule (51) erstreckt.

17. Ultraschall-Motor (21) nach Anspruch 15, wobei sich der fluidtragende wendelförmige Durchgang (141 a, b, c) durch das zylindrische Element (42) erstreckt.

18. Ultraschall-Motor (21) nach einem der vorhergehenden Ansprüche,
wobei das riesig-magnetostriktive Material TERFENOL-D ist.

19. Ultraschall-Motor (21) nach einem der vorhergehenden Ansprüche,
wobei der Ultraschall-Transducer (41) in der Lage ist, kontinuierlich bei voller Leistung zu arbeiten.

20. Ultraschall-Motor (21) nach Anspruch 1,
wobei das Fluss-Rückführungsmaterial eine magnetische Sättigungs-Flussdichte größer als 8 Tesla (8000 Gauss) aufweist.

## Revendications

1. Moteur (21) à ultrasons capable de générer une puissance dépassant les 3 kilowatts comprenant un carter (23) ayant une géométrie prédéterminée, un transducteur (41) ayant un élément actif (42) réalisé à partir d'un matériau magnétostrictif géant, un moyen de refroidissement (141) destiné à refroidir l'élément actif (42) et un moyen (51) destiné à produire un champ électromagnétique qui se déploie à travers au moins une partie de l'élément actif (42), l'élément actif (42) pouvant basculer entre une première forme en l'absence du champ électromagnétique et une seconde forme en présence du champ électromagnétique, un moyen de polarisation pour polariser l'élément actif (42), un moyen (86, 87, 88, 89) de rappel de flux réalisé à partir d'un matériau dont la résistivité électrique est d'au moins 0,01 ohm-cm pour capter le flux magnétique produit par le moyen (51) destiné à produire un champ électromagnétique, et acheminer ce flux à travers l'élément actif (42), un moyen (56) destiné à procurer un signal électrique au moyen (51) destiné à produire un champ électromagnétique et un élément acoustique (96) connecté au transducteur (41) afin de procurer une énergie ultrasonore pour effectuer un travail.

2. Moteur (21) à ultrasons de la revendication 1 dans lequel l'élément actif est un élément cylindrique (42) et dans lequel le moyen destiné à produire un champ électromagnétique est une bobine (51) réalisée à partir d'un matériau conducteur que l'on dispose de manière concentrique autour de l'élément cylindrique (42).

3. Moteur (21) à ultrasons de la revendication 2 dans lequel le moyen de polarisation est un moyen magnétique.

4. Moteur (21) à ultrasons de la revendication 2 dans lequel le moyen magnétique comporte un moyen (71) magnétique tubulaire disposé de manière concentrique autour de l'élément cylindrique (42).

5. Moteur (21) à ultrasons de la revendication 2 dans lequel l'élément cylindrique (42) possède une première et une seconde extrémités (44, 46) opposées dans lequel en outre le moyen de rappel de flux comprend des premier et second éléments (86, 87) de rappel de flux portés par le carter (23), les premier et second éléments (86, 87) de rappel de flux situés de manière adjacente aux première et seconde extrémités (44), (46) de l'élément cylindrique (42).

6. Moteur (21) à ultrasons de la revendication 5 dans lequel les premier et second éléments (86, 87) de rappel de flux sont des premier et second éléments en forme de disques.

7. Moteur (21) à ultrasons de la revendication 1 dans lequel l'élément acoustique (96) est monté sur le transducteur (41) et est réalisé à partir d'un matériau ayant un quart de longueur d'onde de résonance, l'élément acoustique (96) ayant une longueur égale au quart de longueur d'onde de résonance du matériau.

8. Moteur (21) à ultrasons de la revendication 1 dans lequel l'élément acoustique (96) est réalisé à partir d'un métal acoustique.

9. Moteur (21) à ultrasons de la revendication 8 dans lequel le métal acoustique est un alliage de magnésium.

10. Moteur (21) à ultrasons de la revendication 1 dans lequel le moyen de refroidissement comprend un passage (141) dans ou autour du transducteur (41) adapté pour recevoir un fluide de refroidissement, le passage (141) formé d'un matériau qui est un isolant électrique.

11. Moteur (21) à ultrasons de la revendication 10 dans lequel le matériau a une conductivité thermique supérieure à environ 1 W/m-K.

12. Moteur (21) à ultrasons de la revendication 10 dans lequel le passage (141) est formé à partir d'un nitrure de bore pressé à chaud.

13. Moteur (21) à ultrasons de la revendication 10 dans lequel le passage (141) est formé à partir d'un matériau céramique.

14. Moteur (21) à ultrasons de la revendication 10 dans lequel le passage (141) est un passage hélicoïdal (141 a, b, c) transportant du fluide réalisé à partir d'un matériau sélectionné du groupe constitué de nitrure de bore, nitrure d'aluminium, alumine, carbure de silicium, carbure de bore, di borure de titane, carbure de tungstène, nitrure de silicium, spinelle, nitrure de bore pyrolytique, et oxyde de béryllium.

15. Moteur (21) à ultrasons de la revendication 14 dans lequel le passage hélicoïdal (141 a, b, c) transportant du fluide se déploie autour du transducteur (41).

16. Moteur (21) à ultrasons de la revendication 15 dans lequel le passage hélicoïdal (141 a, b, c) transportant du fluide se déploie entre l'élément cylindrique (42) et la bobine (51).

17. Moteur (21) à ultrasons de la revendication 15 dans lequel le passage hélicoïdal (141 a, b, c) transportant du fluide se déploie à travers l'élément cylindrique (42).

18. Moteur (21) à ultrasons selon l'une quelconque des revendications précédentes, dans lequel le matériau magnétostrictif géant est du TERFENOL-D.

19. Moteur (21) à ultrasons selon l'une quelconque des revendications précédentes dans lequel le transducteur (41) à ultrasons peut fonctionner de manière continue à pleine puissance.

20. Moteur (21) à ultrasons de la revendication 1 dans lequel le matériau du moyen de rappel de flux a une densité de flux de saturation magnétique supérieure à 8 tesla (8000 gauss).
